# EUROPEAN PATENT APPLICATION

(11) **EP 1 646 082 A1**
(43) Date of publication of application: **12.04.2006**
(21) Application number: 05001270.7
(22) Date of filing: 21.01.2005
(51) Int. Cl.: H01L 21/68, B65D 1/04, B65D 25/00

(54) **Storage box for wafer shipping box**

(30) Priority: 09.10.2004 CN 200410085238
(71) Applicant: Power Geode Technology Co., Ltd., Taipei 115, Taiwan (TW)
(72) Inventor: Liu, Yu Chuan, Taipei 115 Taiwan (TW)
(74) Representative: Schoppe, Fritz

(57) **Abstract**

A storage box (20) for a wafer shipping box (14, 50) is provided. The storage box (20) includes a first housing member (30), a first fastening element (31, 31'), a second housing member (40) and a second fastening element (41). A closed space is formed by the first housing member (30) and the second housing member (40) for containing the wafer shipping box (14), wherein the first fastening element (31, 31') and the second fastening element (41) are respectively mounted on the first housing member (30) and the second housing member (40). A first fastening device (71) is formed by engaging the first fastening element (31, 31') and the second fastening element (41) for positioning and securing the wafer shipping box (14, 50) in the closed space.

## Description

This invention mainly relates to a storage box for the wafer shipping box, and more particularly to a storage box for the front opening shipping box (FOSB).

Presently, for the semiconductor manufacturers, the front opening shipping boxes in common use have different sizes for containing 4, 8 or 12 inches wafers. A 3.5-ton truck is usually used for transporting front opening shipping boxes from one place to another.

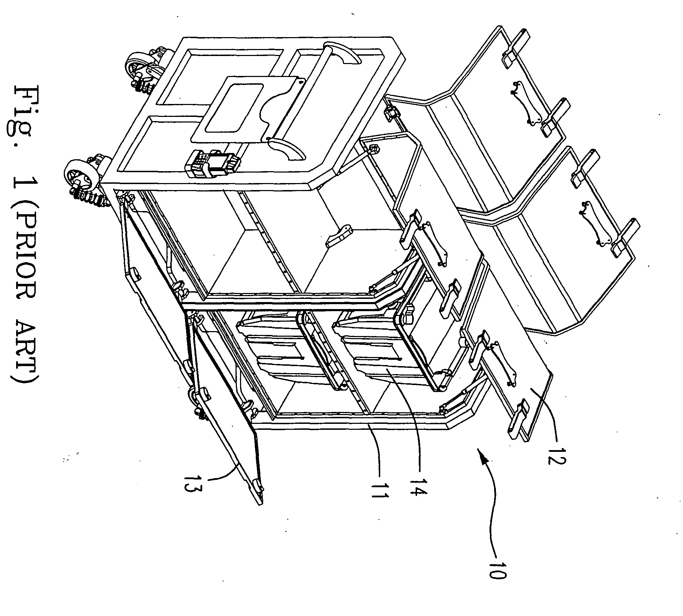

Please refer to Fig. 1, which is a schematic diagram showing a hand truck with covers for transporting the front opening shipping boxes according to the prior art. As shown in Fig. 1, the hand truck 10 has the hand truck body 11, the upper cover 12 and the lower cover 13, and some front opening shipping boxes 14 are contained therein. To ensure that the physical properties of the front opening shipping boxes 14 could be stable, the nitrogen gas is filled into the hand truck 10 after the hand truck body 11 is covered with the upper cover 12 and the lower cover 13. However, the connections among the hand truck body 11, the upper cover 12 and the lower cover 13 are not so well. Therefore, continuously filling nitrogen gas into the hand truck 10 is necessary to maintain the front opening shipping box 14 being an environment with high nitrogen concentration.

Since continuously filling nitrogen gas into the hand truck 10 is troublesome during the course of transporting and it is also inconvenient to operate on a truck, this kind of transportation of the front opening shipping boxes is not desirous.

According to the technical defects described above, for dispensing from the troublesome works of continuously filling nitrogen gas into the hand truck 10 during the course of transportation and overcoming the problem of matainning the wafer shipping boxes in an environment with high nitrogen concentration, the applicant devotes himself to develop a "storage box for wafer shipping box" through a series of experiments, tests and researches. In addition to effectively solving the troublesome problem of the transportation by the hand truck in the prior arts, the storage box according to the present invention also increases the transportation efficiency of the wafer shipping boxes.

In one respect of the present invention, a storage box for a wafer shipping box is provided. A storage box for a wafer shipping box includes a first housing member for containing a first portion of the wafer shipping box, a second housing member for containing a second portion of the wafer shipping box, a first fastening element mounted on the first housing member and a second fastening element mounted on the second housing member. A closed space is formed by the first housing member and the second housing member for containing the wafer shipping box.

Preferably, the first housing member is an upper cover, and the first fastening element and the second fastening element are mortises.

Preferably, the storage box further includes a plate, wherein the plate has a protruding tenon and extending arms mounted thereon for being respectively engaged to the first fastening element and the second fastening element to form a first fastening device, and the plate has a central protruding portion and a flange for unfastening the first fastening device.

Preferably, the second fastening element has a first and a second "Π"-shaped mortises for respectively inserting therein each of the extending arms of the plate, the first fastening device further includes a prop mounted on the second housing member for propping a positioning terminal of the plate, and the first "Π"-shaped mortise, the second "Π"-shaped mortise and the prop are used for holding the plate.

Preferably, the storage box further includes a second fastening device, wherein a first fastening plane is formed by the first and the second fastening devices for positioning and securing the first housing member and the second housing member.

Preferably, the storage box further includes a third and a fourth fastening devices, wherein a second fastening plane is formed by the third and the fourth fastening devices for positioning and securing the first housing member and the second housing member.

Preferably, the storage box further includes a fifth and a sixth fastening devices, wherein a third fastening plane is formed by the fifth and the sixth fastening devices for positioning and securing the first housing member and the second housing member.

Preferably, the storage box further includes a seventh and a eighth fastening devices, wherein a fourth fastening plane is formed by the seventh and the eighth fastening devices for positioning and securing the first housing member and the second housing member.

Preferably, the storage box further includes a stacking box mounted thereon, wherein the first housing member of the storage box includes a first slot and a first tenon thereon, the stacking box includes a third housing member having a second slot and a second tenon thereon for being respectively engaged with the first tenon and the first slot for securing the stacking box on the storage box.

Preferably, the first slot of the first housing member includes a lateral wall having a central slot thereon, and the first housing member, the second housing member and the third housing member have identical shapes for being stacked up with one another.

Preferably, the first housing member includes a valve and a barometer for measuring a retained amount of nitrogen in the storage box.

Preferably, the storage box further includes a shockproof foam sponge for protecting the wafer shipping box from a shock.

In another aspect of the present invention, a storage box is provided. The storage box includes a first housing member for containing a first portion of an object, a second housing member for containing a second portion of the object, a first fastening element being mounted on the first housing member, a second fastening element being mounted on the second housing member and a second fastening device. A closed space is formed by the first housing member and the second housing member for containing the object. A first fastening device is formed by engaging the first fastening element and the second fastening element for positioning and securing the object therein the closed space. A first fastening plane is formed by the second fastening device and the first fastening device for positioning and securing the first housing member and the second housing member. A third and a fourth fastening devices for forming a second fastening plane for positioning and securing the first housing member and the second housing member.

Preferably, the object is a wafer shipping box.

Preferably, the first housing member is an upper cover, and the first fastening element and the second fastening element are mortises.

Preferably, the storage box further includes a plate, wherein the plate has a protruding tenon mounted thereon for being engaged to the first fastening element, and the plate has a central protruding portion and a flange for unfastening the first fastening device.

In another aspect of the present invention, a storage box is provided. The storage box includes a first housing member for containing a first portion of an object, a second housing member for containing a second portion of the object, a first fastening element being mounted on the first housing member, a second fastening element being mounted on the second housing member and a barometer mounted on the first housing member for measuring an amount of the gas in the storage box. A closed space is formed by the first housing member and the second housing member for containing the object. A first fastening device is formed by engaging the first fastening element and the second fastening element for positioning and securing the object therein the closed space.

Preferably, the object is a wafer shipping box, and the gas is a nitrogen.

Preferably, the storage box further includes a second fastening device, wherein a first fastening plane is formed by the second fastening device and the first fastening device for positioning and securing the first housing member and the second housing member.

Preferably, the first housing member is an upper cover, and the first fastening element and the second fastening element are mortises.

The above contents and advantages of the present invention will become more readily apparent to those ordinarily skilled in the art after reviewing the following detailed descriptions and accompanying drawings, in which:
Fig. 1 is a schematic diagram showing a hand truck with covers for transporting front opening shipping boxes according to the prior art;
Fig. 2 is a schematic view showing the storage box according to a preferred embodiment of the present invention;
Figs. 3(a)-3(b) are schematic views showing the first housing member of the storage box shown in Fig. 2;
Figs. 4(a)-4(b) are schematic views showing the second housing member of the storage box shown in Fig. 2;
Fig. 5 is a schematic view showing a wafer shipping box and the storage box shown in Fig. 2;
Figs. 6(a)-6(b) are respectively the vertical view and the lateral view showing a plate of the storage box shown in Fig. 2;
Fig 7 is a top view of the fastening devices for the storage box shown in Fig. 2;
Fig. 8 is a schematic view showing the stacking box and the storage box shown in Fig. 2;
Fig. 9 is a schematic view showing the storage box shown in Fig. 2 with a barometer;
Fig. 10 is a schematic view showing the storage box according to another preferred embodiment of the present invention; and
Fig. 11(a)-11(b) are respectively the vertical view and the lateral view showing a plate of the storage box shown in Fig. 10.

### EMBODIMENT OF STORAGE BOX FOR WAFER SHIPPING BOX

The present invention will now be described more specifically with reference to the following embodiments. It is to be noted that the following descriptions of preferred embodiments of this invention are presented herein for purpose of illustration and description only; it is not intended to be exhaustive or to be limited to the precise form disclosed.

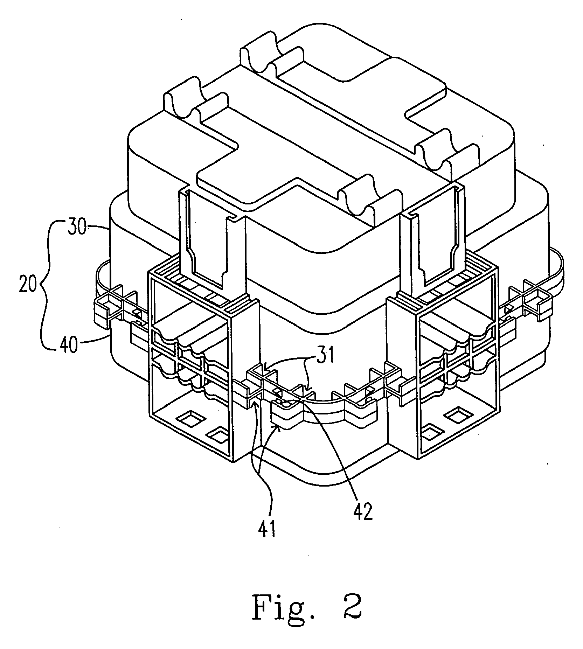

Please refer to Fig. 2, which is a schematic view showing a storage box according to a preferred embodiment of the present invention. As shown in Fig. 2, the storage box 20 has the first housing member 30 and the second housing member 40, wherein the first housing member 30 has the first fastening element 31, and the second housing member 40 has the second fastening element 41 and the prop 42. The length and the width of the storage box 20 are the same and the storage box 20 is designed as a square with its arc corners.

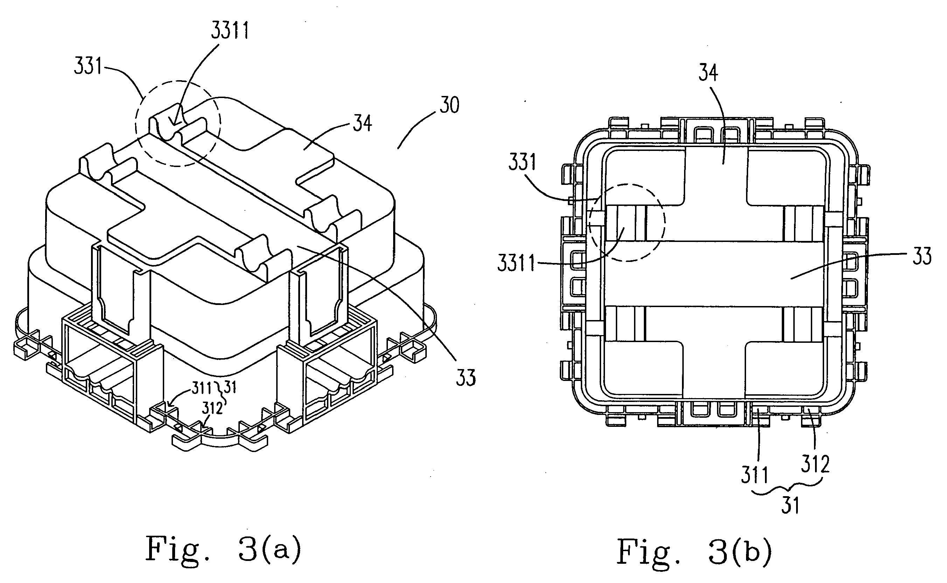

Please refer to Figs. 3(a)-3(b), which are the schematic views showing the first housing member 30 of the storage box 20 shown in Fig. 2. As shown in Figs. 3(a)-3(b), the first housing member 30 is an upper cover, and the first fastening element 31 has two mortises 311 and 312. The first housing member 30 has the slot 33 and the tenon 34, wherein the slot 33 includes a lateral wall 331 having a central slot 3311 thereon.

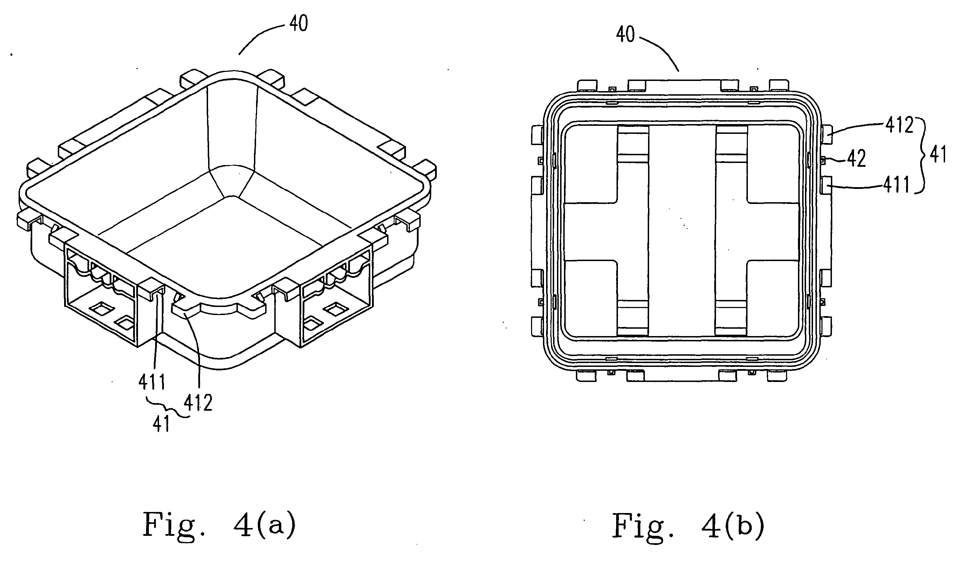

Please refer to Figs. 4(a)-(b), which are schematic views showing the second housing member 40 of the storage box 20 shown in Fig. 2. The second housing member 40 has the second fastening element 41 and the prop 42, wherein the second fastening element 41 has two "Π"-shaped mortises 411 and 412.

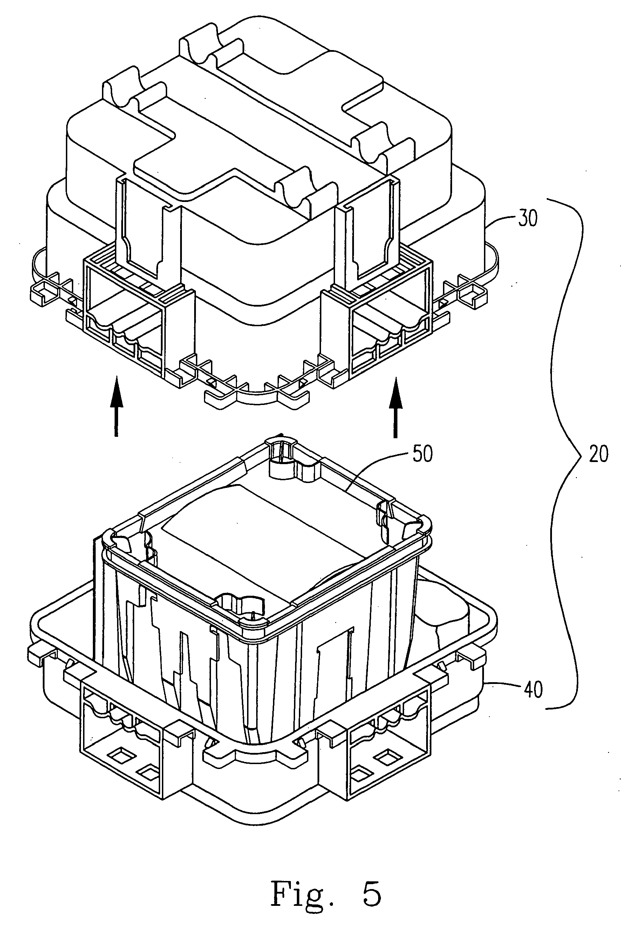

Please refer to Fig. 5, which is a schematic view showing a wafer shipping box and the storage box 20 shown in Fig. 2. As shown in Fig. 5, the first housing member 30 and the second housing member 40 of the storage box 20 are used for containing therein the wafer shipping box 50. It should be noted that the storage box 20 could be used for containing therein other objects.

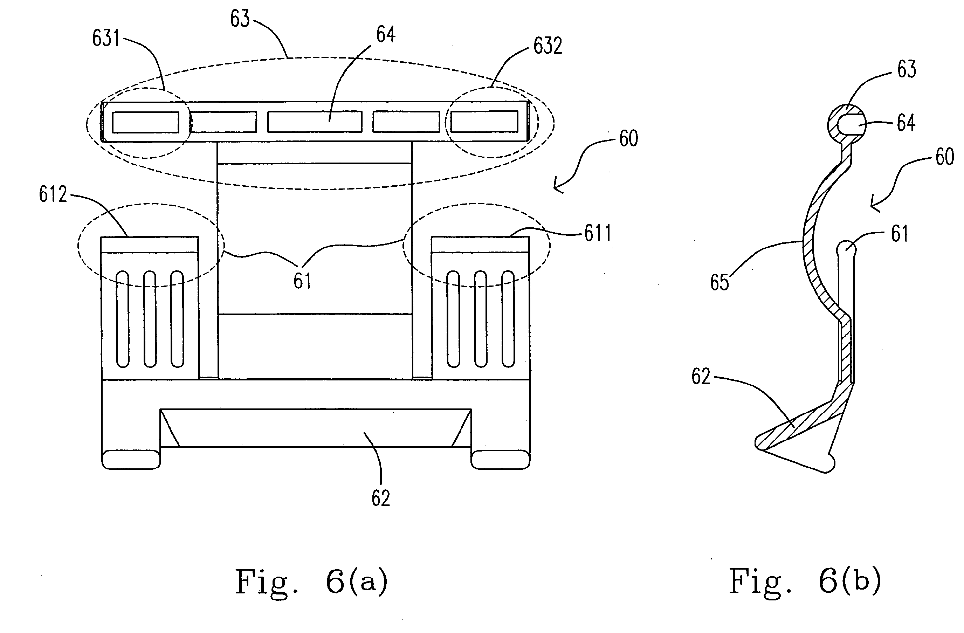

The storage box 20 further includes a plate. Please refer to Figs. 6(a)-6(b), which are respectively the vertical view and the lateral view of the plate of the storage box 20 shown in Fig. 2. As shown in Fig. 6(a), the plate 60 includes the protruding tenon 61, the flange 62, the extending arm 63 and the positioning terminal 64. The protruding tenon 61 has two protruding tenons 611 and 612, and the extending arm 63 has the left and the right extending arms 631 and 632. As shown in Fig. 6(b), except for the protruding tenon 61, the flange 62, the extending arm 63 and the positioning terminal 64, the plate 60 further includes the central protruding portion 65.

Please refer to Figs. 2, 3(a), 3(b), 4, 6(a) and 6(b). The first housing member 30 and the second housing member 40 is positioned and secured by a fastening device (including the protruding tenon 61, the extending arm 63, the first fastening element 31 and the second fastening element 41) formed by respectively engaging the protruding tenon 61 and the extending arm 63 to the first fastening element 31 and the second fastening element 41.

The engagement of the first housing member 30 and the second housing member 40 by the fastening device (including the protruding tenon 61, the extending arm 63, the first fastening element 31 and the second fastening element 41) is detailed described as follows. As shown in Figs. 3, 4 and 6(b), the protruding tenon 61 has two protruding tenons 611 and 612, the extending arm 63 has the left and the right extending arms 631 and 632, the first fastening element 31 has two mortises 311 and 312 and the second fastening element 41 has two "Π"-shaped mortises 411 and 412, and by propping the prop 42 to the positioning terminal 64. Therefore, the first "Π "-shaped mortise 411, the second "Π "-shaped mortise 412 and the prop 42 are used for holding the plate 60. The flange 62 and the central protruding portion 65 are used for unfastening the fastening device (including the protruding tenon 61, the extending arm 63, the first fastening element 31 and the second fastening element 41). It should be noted that the elements 31, 41, 61 and 63 of the fastening devices for engaging the first housing member 30 and the second housing member 40 could be replaced with other engaging elements.

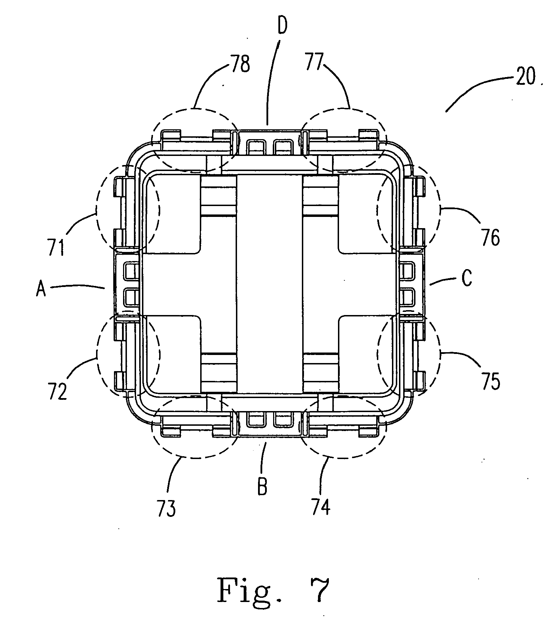

Please refer to Fig. 7, which is a top view of the storage box 20 and the fastening devices. As shown in Fig. 7(a), the storage box 20 shown in Fig. 2 has the first fastening device 71. The storage box 20 could further include the second fastening device 72. The first fastening device 71 and the second fastening device 72 are located on the first fastening side A of the storage box 20. Furthermore, the storage box 20 shown in Fig. 2 could includes the third, the fourth, the fifth, the sixth, the seventh and the eighth fastening devices 73, 74, 75, 76, 77 and 78. The third fastening device 73 and the fourth fastening device 74 are located on the second fastening side B of the storage box 20. The fifth fastening device 75 and the sixth fastening device 76 are located on the third fastening side C of the storage box 20. The seventh fastening device 77 and the eighth fastening device 78 are located on the fourth fastening side D of the storage box 20. These fastening devices (10, 72, 73, 74, 75, 76, 77 and 78) are used for positioning and securing the first housing member 30 (refer to Fig. 5) and the second housing member 40 (refer to Fig. 5).

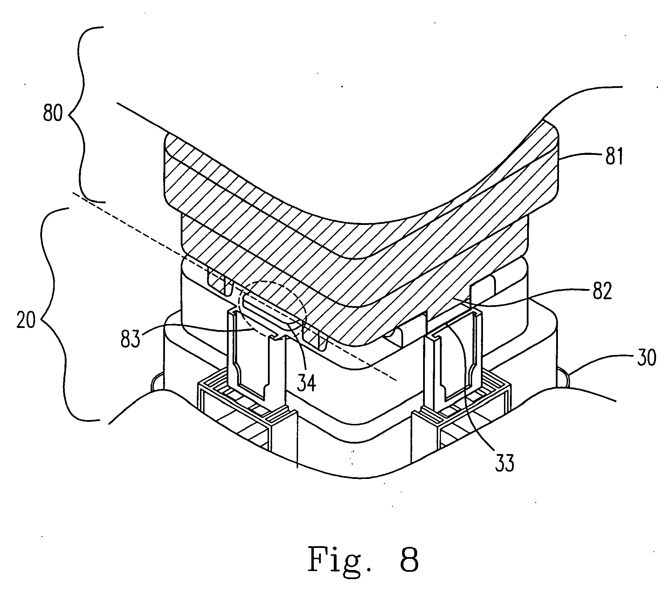

Please refer to Fig. 8, the storage box 20 further includes thereon the stacking box 80, wherein only the upper half of the storage box 20 and the lower half of the stacking box 80 are shown. Please be advised that the first, second and third housing members (30, 40 and 81) have identical shapes for being stacked up with each other. Since Fig. 8 is used for showing the engagement between the storage box 20 and the stacking box 80, the body of the lower half of storage box 80 is drawn in a simplified form. The stacking box 80 includes the third housing member 81 for being stacked on the first housing member 30 shown in Fig. 2, and the third housing member 81 has the slot 82 and the tenon 83. The slot 82 and the tenon 83 of the third housing member 81 are respectively engaged with the tenon 34 and the slot 33 of the first housing member 30 for securing the stacking box 80 and the storage box 20.

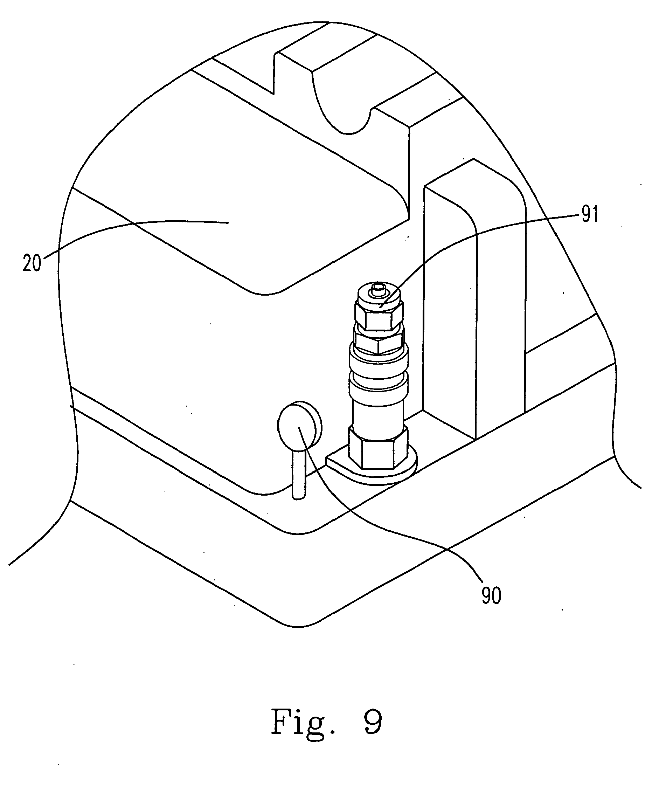

Furthermore, please refer to Fig. 9, the storage box 20 shown in Fig. 2 includes the barometer 90 for measuring a retained amount of nitrogen in the storage box 20, and the valve 91 for filling in or extracting out the gas containing therein. Before filling the nitrogen gas into the storage box 20, it is preferable to precede the air-extracting procedure for about half second.

Furthermore, the storage box 20 could include a shockproof foam sponge (not shown) for protecting the wafer shipping box 50 from a shock.

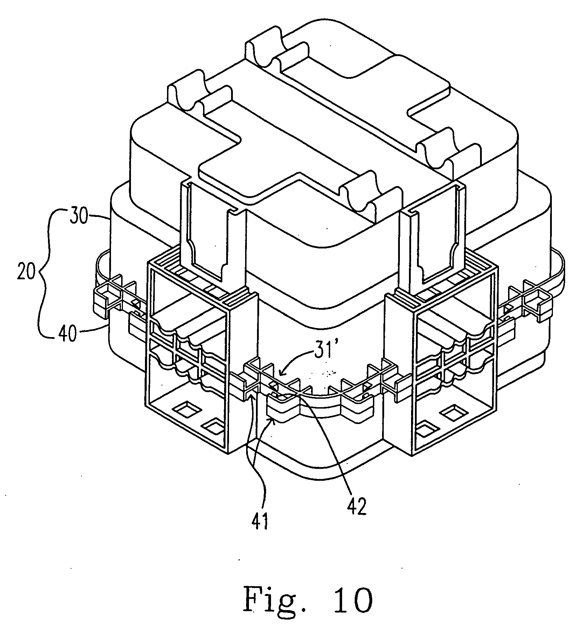

Please refer to Fig. 10, which is a schematic view showing a storage box 100 according to another preferred embodiment of the present invention. It should be noted that the configuration of the storage box 100 shown in Fig. 10 is similar to that of the storage box 20 shown in Fig. 2. Actually, most of the elements of the storage box 100 are also the same as those of the storage box 20. The differences between them are the storage box 100 has another fastening element 31' and another plate which will be described below rather than having the first fastening element 31 and the plate 60 for the storage box 20. The detailed structure of the storage box 100 will be described as follows.

As shown in Fig. 10, the storage box 10 has the first housing member 30 and the second housing member 40, wherein the first housing member 30 has another fastening element 31', and the second housing member 40 has the second fastening element 41 and the prop 42. The length and the width of the storage box 100 are the same and the storage box 100 is designed as a square with its arc corners.

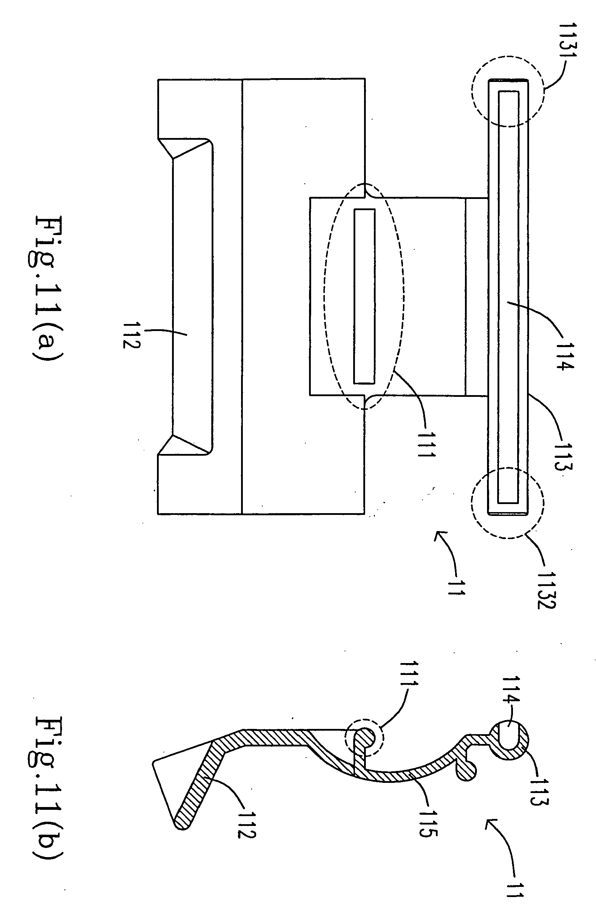

The storage box 100 further includes a plate. Please refer to Figs. 11(a)-11(b), which are respectively the vertical view and the lateral view of the plate of the storage box 100 shown in Fig. 10. As shown in Fig. 11(a), the plate 110 includes the protruding tenon 111, the flange 112, the extending arm 113 and the positioning terminal 114. The protruding tenon 111 is in the central portion of the plate 110, and the extending arm 113 has the left and the right extending arms 1131 and 1132. As shown in Fig. 11(b), except for the protruding tenon 111, the flange 112, the extending arm 113 and the positioning terminal 114, the plate 110 further includes the central protruding portion 115.

Please refer to Figs. 10, 11(a) and 11(b). The first housing member 30 and the second housing member 40 is positioned and secured by a fastening device (including the protruding tenon 111, the extending arm 113, the first fastening element 31 and the second fastening element 41) formed by respectively engaging the protruding tenon 111 and the extending arm 113 to the first fastening element 31 and the second fastening element 41.

Therefore, the storage box provided in the present invention indeed effectively overcomes the disadvantages of the prior art. To sum up, the storage box provided in the present invention does have the novelty, the progressiveness, and utility in the industry.

## Claims

1. A storage box (20) for a wafer shipping box (14, 50), **characterized in that**:
a first housing member (30) for containing a first portion of the wafer shipping box (14, 50);
a first fastening element (31, 31') mounted on the first housing member (30);
a second housing member (40) for containing a second portion of the wafer shipping box (14, 50), and
a second fastening element (41) mounted on the second housing member (40), wherein a closed space is formed by the first housing member (30) and the second housing member (40) for containing the wafer shipping box (14, 50).

2. The storage box (20) as claimed in claim 1, **characterized in that** the first housing member (30) is an upper cover, and the first fastening element (31, 31') and the second fastening element (41) are mortises.

3. The storage box (20) as claimed in claim 2 **characterized by** comprising a plate (60, 11), wherein the plate (60, 11) has a protruding tenon (61, 111) and extending arms (63, 113) mounted thereon for being respectively engaged to the first fastening element (31, 31') and the second fastening element (41) to form a first fastening device (71), and the plate (60, 11) has a central protruding portion (65, 115) and a flange (62, 112) for unfastening the first fastening device (71).

4. The storage box (20) as claimed in claim 3, **characterized in that** the second fastening element (41) has a first and a second "Π"-shaped mortises (411, 412) for respectively inserting therein each of the extending arms (631, 1131) (632, 1132, 1132) of the plate (60, 11), the first fastening device (71) further includes a prop (42) mounted on the second housing member (40) for propping a positioning terminal (64, 114) of the plate (60, 11), and the first "Π"-shaped mortise (411), the second "Π"-shaped mortise (412) and the prop (42) are used for holding the plate (60, 11).

5. The storage box (20) as claimed in claim 1 **characterized by** comprising a second fastening device (72), wherein a first fastening plane (A) is formed by the second fastening device (72) and the first fastening device (71) for positioning and securing the first housing member (30) and the second housing member (40).

6. The storage box (20) as claimed in claim 1 **characterized by** comprising a third and a fourth fastening devices (73, 74), wherein a second fastening plane (B) is formed by the third and the fourth fastening devices (73, 74) for positioning and securing the first housing member (30) and the second housing member (40).

7. The storage box (20) as claimed in claim 1 **characterized by** comprising a fifth and a sixth fastening devices (75, 76), wherein a third fastening plane (C) is formed by the fifth and the sixth fastening devices (75, 76) for positioning and securing the first housing member (30) and the second housing member (40).

8. The storage box (20) as claimed in claim 1 **characterized by** comprising a seventh and a eighth fastening devices (77, 78), wherein a fourth fastening plane (D) is formed by the seventh and the eighth fastening devices (77, 78) for positioning and securing the first housing member (30) and the second housing member (40).

9. The storage box (20) as claimed in claim 1 **characterized by** comprising a stacking box (80) mounted thereon, wherein the first housing member (30) of the storage box (20) includes a first slot (33) and a first tenon (34) thereon, the stacking box (80) includes a third housing member (81) having a second slot (82) and a second tenon (83) thereon for being respectively engaged with the first tenon (34) and the first slot (33) for securing the stacking box (80) on the storage box (20).

10. The storage box (20) as claimed in claim 9, **characterized in that** the first slot (33) of the first housing member (30) includes a lateral wall (331) having a central slot (3311) thereon, and the first housing member (30), the second housing member (40) and the third housing member (81) have identical shapes for being stacked up with one another.

11. The storage box (20) as claimed in claim 1, **characterized in that** the first housing member (30) includes a valve (91) and a barometer (90) for measuring a retained amount of nitrogen in the storage box (20).

12. The storage box (20) as claimed in claim 1 **characterized by** comprising a shockproof foam sponge for protecting the wafer shipping box (14, 50) from a shock.

13. A storage box (20), **characterized in that**:
a first housing member (30) for containing a first portion of an object;
a first fastening element (31, 31') being mounted on the first housing member (30);
a second housing member (40) for containing a second portion of the object,
wherein a closed space is formed by the first housing member (30) and the second housing member (40) for containing the object;
a second fastening element (41) being mounted on the second housing member (40), wherein a first fastening device (71) is formed by engaging the first fastening element (31, 31') and the second fastening element (41) for positioning and securing the object therein the closed space;
a second fastening device (72), wherein a first fastening plane (A) is formed by the second fastening device (72) and the first fastening device (71) for positioning and securing the first housing member (30) and the second housing member (40); and
a third and a fourth fastening devices (73, 74) for forming a second fastening plane (B) for positioning and securing the first housing member (30) and the second housing member (40).

14. The storage box (20) as claimed in claim 13, **characterized in that** the object is a wafer shipping box (14, 50).

15. The storage box as claimed in claim 13, **characterized in that** the first housing member (30) is an upper cover, and the first fastening element (31, 31') and the second fastening element (41) are mortises.

16. The storage box (20) as claimed in claim 15 **characterized by** comprising a plate (60, 11), wherein the plate (60, 11) has a protruding tenon (61, 111) mounted thereon for being engaged to the first fastening element (31, 31'), and the plate (60, 11) has a central protruding portion (65, 115) and a flange (62, 112) for unfastening the first fastening device (71).

17. A storage box (20), **characterized in that**:
a first housing member (30) for containing a first portion of an object;
a first fastening element (31, 31') being mounted on the first housing member;
a second housing member (40) for containing a second portion of the object,
wherein a closed space is formed by the first housing member (30) and the second housing member (40) for containing the object;
a second fastening element (41) being mounted on the second housing member (40), wherein a first fastening device (71) is formed by engaging the first fastening element (31, 31') and the second fastening element (41) for positioning and securing the object therein the closed space; and
a barometer (90) mounted on the first housing member (30) for measuring an amount of a gas in the storage box (20).

18. The storage box (20) as claimed in claim 17, **characterized in that** the object is a wafer shipping box (14, 50), and the gas is a nitrogen.

19. The storage box (20) as claimed in claim 17 **characterized by** comprising a second fastening device (72), wherein a first fastening plane (A) is formed by the second fastening device (72) and the first fastening device (72) for positioning and securing the first housing member (30) and the second housing member (40).

20. The storage box (20) as claimed in claim 17, **characterized in that** the first housing member (30) is an upper cover, and the first fastening element (31, 31') and the second fastening element (41) are mortis.
